# EUROPEAN PATENT APPLICATION

(11) **EP 4 776 765 A1**
(43) Date of publication of application: **15.07.2026**
(21) Application number: 23951129.8
(22) Date of filing: 05.09.2023
(51) Int. Cl.: H05K 7/20

(54) **COOLING ASSEMBLY**

(71) Applicant: Delta Electronics, Inc., Taoyuan City 333 (TW)
(72) Inventor: TSENG, Wei-chen, Taoyuan City Taiwan 333 (TW); FAN, Kang-yu, Taoyuan City Taiwan 333 (TW)
(74) Representative: Riccardi, Elisa
(86) International application number: PCT/CN2023/117108
(87) International publication number: WO 2025/050301

(57) **Abstract**

Provided in the present invention is a cooling assembly, which comprises a housing, at least one power module and a cooling plate. The housing is internally provided with a first chamber and a second chamber. The top portions of the ends of a same side of the first chamber and the second chamber are respectively provided with an outlet and an inlet. The power module is located in the housing and at least partially overlaps the first chamber and the second chamber. The cooling plate is arranged on the power module. The cooling plate comprises at least two linear flow channels and a curved flow channel communicated with the ends of a same side of the two linear flow channels. When a working fluid flows from the first chamber to the second chamber successively through the outlet of the first chamber, an inlet of the cooling plate, one of the two linear flow channels, the curved flow channel, the other one of the two linear flow channels, an outlet of the cooling plate and the inlet of the second chamber, the working fluid has a same unit area average temperature along different cross sections in the width direction of the cooling plate.

## Description

### BACKGROUND

### Field of Invention

The present disclosure relates to a cooling assembly, especially relates to a cooling assembly for cooling a power module.

### Description of Related Art

The vehicle power supply may include a power module, a DC input capacitor module and an AC output bus bar module. In order to effectively cool the aforementioned modules, generally speaking, the structure of a cooling assembly is quite complex. For example, in addition to a casing, a traditional cooling assembly needs to have the configuration of plural cooling plates to provide water cooling for the power module, the capacitor module, and the bus bar module respectively. Therefore, material costs and occupied space are difficult to be reduced, which limits vehicle systems.

A water cooling system usually provides low-temperature water at the inlet of a casing, and drain high-temperature water at an outlet after the water flowing through high-temperature components. Since the temperature of the water will rise due to the accumulation of heat during the water flowing through the high-temperature components (such as the aforementioned modules), if the positions of the flow channel, the inlet, and the outlet are not specially designed, the water will easily generate an excessive temperature gradient, which may cause insufficient cooling of modules near the outlet, resulting in reduced module performance or even damage, and also lead to material fatigue.

### SUMMARY

According to some embodiments of the present disclosure, a cooling assembly includes a casing, at least one power module, and a cooling plate. The casing has a first chamber and a second chamber therein. The top portions of the first chamber and the second chamber respectively have an outlet and an inlet at the same-side ends of the first chamber and the second chamber. The power module is located in the casing and at least partially overlaps with the first chamber and the second chamber. The cooling plate is disposed on the power module. A side of the cooling plate has an inlet and an outlet. The cooling plate includes at least two linear flow channels and a curved flow channel communicated with same-side ends of the two linear flow channels. When a working fluid flows from the first chamber to the second chamber and sequentially passes through the outlet of the first chamber, the inlet of the cooling plate, one of the two linear flow channels, the curved flow channel, the other of the two linear flow channels, the outlet of the cooling plate, and the inlet of the second chamber, different sections of the working fluid along a width direction of the cooling plate have a same average temperature per unit area.

According to some embodiments of the present disclosure, a cooling assembly includes a casing, at least one power module, and a cooling plate. The casing has a first chamber and a second chamber therein, wherein top portions of the first chamber and the second chamber respectively have an outlet and an inlet at same-side ends of the first chamber and the second chamber. The power module is located in the casing and at least partially overlaps with the first chamber and the second chamber. The cooling plate is disposed on the power module, wherein a side of the cooling plate has an inlet and an outlet, the cooling plate includes at least two linear flow channels and a curved flow channel communicated with same-side ends of the two linear flow channels. One of the two linear flow channels is communicated with the inlet of the cooling plate, the other of the two linear flow channels is communicated with the outlet of the cooling plate. When a working fluid flows through the one of the two linear flow channels, a temperature of the working fluid gradually increases away from the inlet of the cooling plate. When the working fluid flows through the other of the two linear flow channels, a temperature of the working fluid gradually decreases away from the outlet of the cooling plate.

In the aforementioned embodiments of the present disclosure, the top portions of the first chamber and the second chamber of the casing respectively have the outlet and the inlet at the same-side ends of the first chamber and the second chamber, the cooling plate includes the two linear flow channels and the curved flow channel, and a side of the cooling plate has the inlet and the outlet. Therefore, when the working fluid flows from the first chamber to the second chamber and sequentially passes through the outlet of the first chamber, the inlet of the cooling plate, one of the two linear flow channels, the curved flow channel, the other of the two linear flow channels, the outlet of the cooling plate, and the inlet of the second chamber, the two-layer flow of the working fluid in the lower-layer casing and the upper-layer cooling plate, the two-way flow of the working fluid in the first chamber and the second chamber, and the two-way flow of the working fluid in the two linear flow channels of the cooling plate can be realized. Through the above design, different sections of the working fluid along the width direction of the cooling plate have the same average temperature per unit area. For example, the temperature of the working fluid in the linear flow channel gradually increases away from the inlet of the cooling plate, and the temperature of the working fluid in the other linear flow channel gradually decreases away from the outlet of the cooling plate. The cooling assembly merely has the single cooling plate to provide water cooling for the power module and other electronic components (e.g., a capacitor module and a bus bar module) disposed in the casing, and thus material costs and occupied space can be effectively reduced, which is beneficial to a vehicle system. Moreover, since the cooling assembly achieves two-layer flow and two-way flow, the working fluid does not easily generate an excessive temperature gradient, thereby maintaining module performance and extending service life.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
Fig. 1 is a perspective view of a cooling assembly according to one embodiment of the present disclosure.
Fig. 2 is an exploded view of the cooling assembly of Fig. 1.
Fig. 3 is a schematic view of a path of a working fluid when flowing at a lower side of a casing of Fig. 1.
Fig. 4 is a perspective view of the cooling assembly of Fig. 1 when a cover of a cooling plate is omitted.
Fig. 5 is a schematic view of a path of the working fluid when flowing in a cross section of the cooling assembly of Fig. 1 taken along line 5-5.
Fig. 6 is a schematic view of a path of the working fluid when flowing in the cooling plate of Fig. 1.
Fig. 7 is a top view of the cooling assembly of Fig. 1.
Fig. 8 is a top view of a cooling plate according to another embodiment of the present disclosure, in which the cover of the cooling plate is omitted.

Reference numerals in the drawings:
100: cooling assembly
110: casing
112: first chamber
114: second chamber
120a,120b,120c: power module
130,130a: cooling plate
131a,131b,131c,131d,131e,131f: linear flow channel
132: base
133,133a,133b,133c: curved flow channel
134:cover
136,136a,136b,136c: partition
140: capacitor module
150: bus bar module
5-5: line
A1,A2,A3,B1,B2,B3,C1,C2,C3,D1,D2,D3: area
F1,F2,F3,F4,F5,F6: water flow
L1,L2,L3: section
O1: outlet
O11: inlet
O2: inlet
O22: outlet
Oᵢₙ: water inlet
Oₒᵤₜ: water outlet

### DETAILED DESCRIPTION

The following disclosure provides many different embodiments, or examples, for implementing different features of the provided subject matter. Specific examples of components and arrangements are described below to simplify the present disclosure. These are, of course, merely examples and are not intended to be limiting. In addition, the present disclosure may repeat reference numerals and/or letters in the various examples. This repetition is for the purpose of simplicity and clarity and does not in itself dictate a relationship between the various embodiments and/or configurations discussed.

Further, spatially relative terms, such as "beneath," "below," "lower," "above," "upper" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

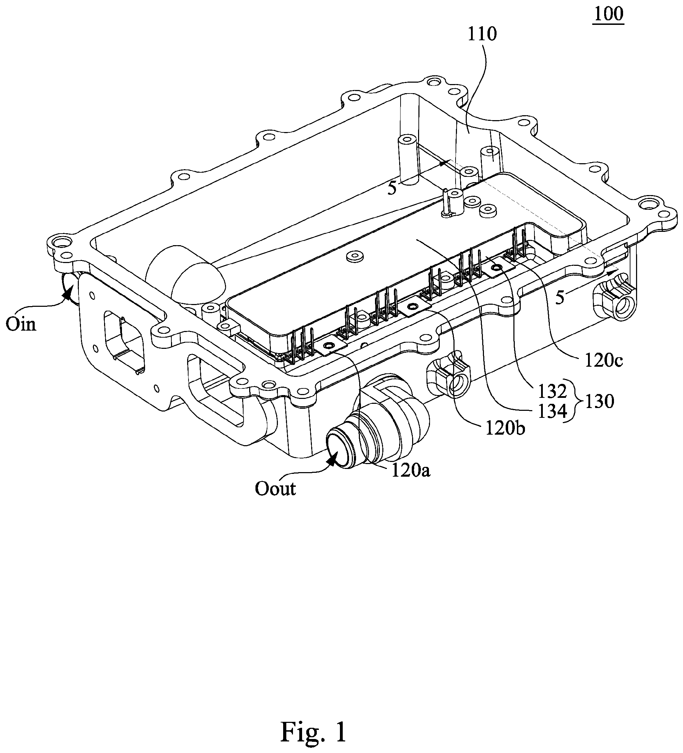

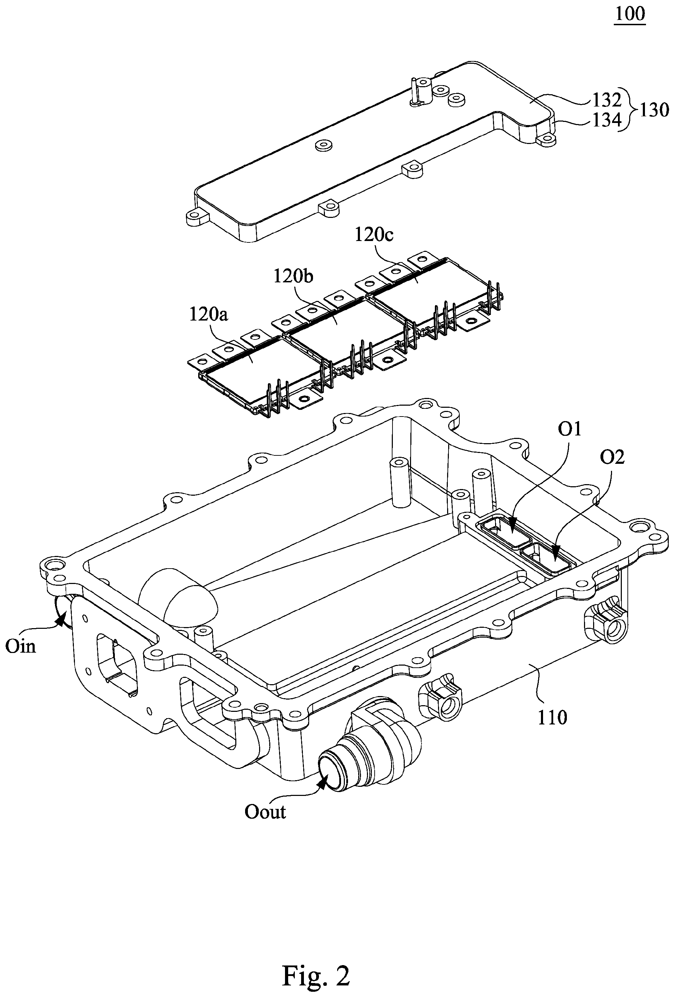

Fig. 1 is a perspective view of a cooling assembly 100 according to one embodiment of the present disclosure. Fig. 2 is an exploded view of the cooling assembly 100 of Fig. 1. As shown in Fig. 1 and Fig. 2, the cooling assembly 100 includes a casing 110, power modules 120a, 120b, and 120c, and a cooling plate 130. The power modules 120a, 120b, and 120c and the cooling plate 130 are located in the casing 110, and the cooling plate 130 is disposed on the power modules 120a, 120b, and 120c. The cooling plate 130 may include a base 132 and a cover 134 located on the base 132. The cover 134 is tightly connected to the base 132 to allow a working fluid to flow therein to prevent leakage of the working fluid. Although Fig. 2 illustrates three power modules 120a, 120b, and 120c, the present disclosure is not limited by the number of power modules. The cooling assembly 100 can be applied to a vehicle driver. In addition to accommodating the power modules 120a, 120b, and 120c, the casing 110 can also accommodate a DC input capacitor module and an AC output bus bar module respectively at two sides of the cooling plate 130, but the present disclosure is not limited in this regard. The cooling assembly 100 has a lower flow channel and an upper channel, in which the lower flow channel is located in the bottom portion of the casing 110, and the upper channel is located in the cooling plate 130. In the following description, the structures of the casing 110 and the cooling plate 130 will be explained in detail.

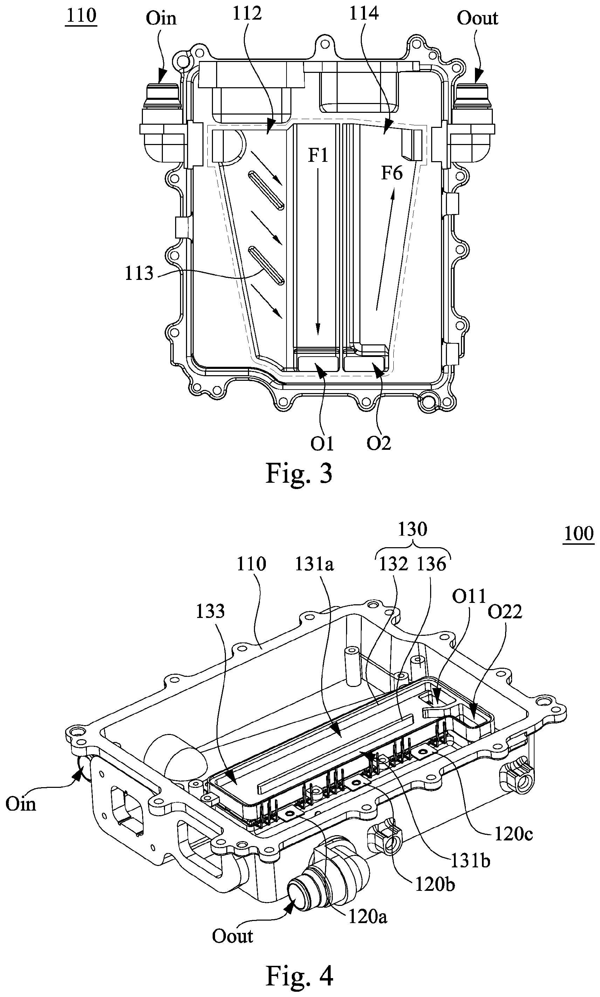

Fig. 3 is a schematic view of the path of a working fluid when flowing at the lower side of the casing 110 of Fig. 1, in which a dashed area may be a portion of the bottom plated of the casing 110. As shown in Fig. 2 and Fig. 3, the casing 110 has a first chamber 112 and a second chamber 114 therein. The first chamber 112 and the second chamber 114 are located in the lower layer of the casing 110, and may serve as lower-layer flow channels. The first chamber 112 and the second chamber 114 are separated from each other without direct communication. Furthermore, the first chamber 112 is communicated with an water inlet Oᵢₙ, the second chamber 114 is communicated with an water outlet Oₒᵤₜ, and the top portions of the first chamber 112 and the second chamber 114 respectively have an outlet O1 and an inlet O2 at the same-side ends of the first chamber 112 and the second chamber 114, as shown in the right side of Fig. 2 and the lower side of Fig. 3. After the working fluid (e.g., water) flows into the first chamber 112 from the water inlet Oᵢₙ, a water flow F1 is formed. The water flow F1 can flow out into the cooling plate 130 in the upper layer of the casing 110 through the outlet O1 of the first chamber 112 without flowing into the second chamber 114. Moreover, a water flow passing through the cooling plate 130 (to be described hereinafter) may flow into the second chamber 114 from the inlet O2 of the second chamber 114, thereby forming a water flow F6. The water flow F6 can flow out from the water outlet Oₒᵤₜ without flowing back to the first chamber 112.

In this embodiment, the power module 120a, 120b, and 120c at least partially overlap with the first chamber 112 and the second chamber 114, and thus the water flow F1 and the water flow F6 can dissipate heat from the bottom portions of the power modules 120a, 120b, and 120c. In addition, the casing 110 may further include at least one flow guiding protruding rib 113. The flow guiding protruding rib 113 is located in the first chamber 112 and capable of regulating a water flow, thereby adjusting flow distribution and velocity of the working fluid in the first chamber 112. Although Fig. 3 shows three flow guiding protruding ribs 113, the present disclosure is not limited by the number, setting angles, or sizes of low guiding protruding ribs.

In the following description, the flow mechanism of the water flow F1 to the water flow F6 will be described in detail.

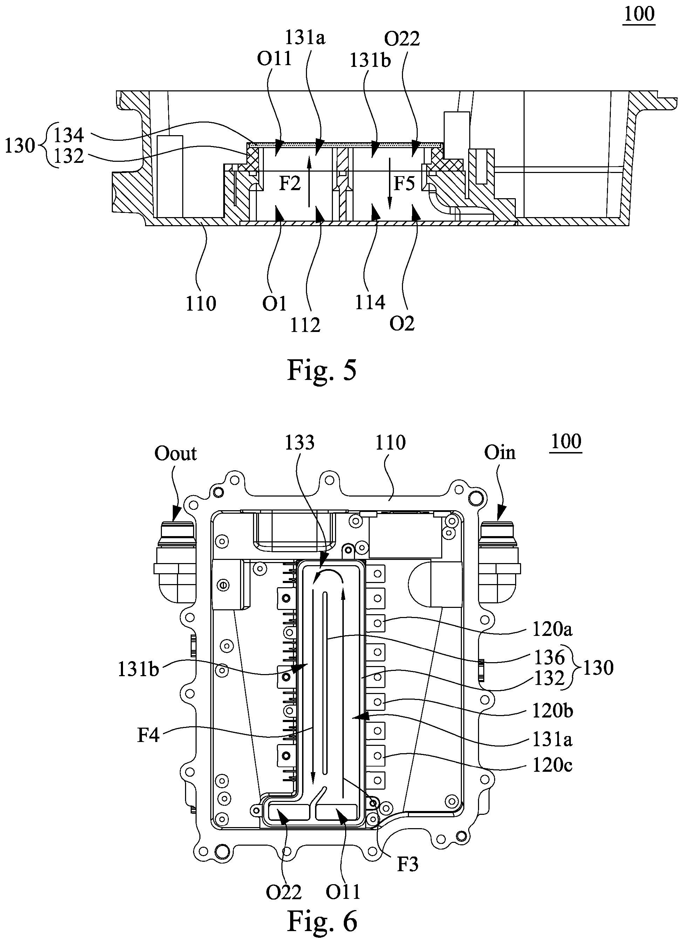

Fig. 4 is a perspective view of the cooling assembly 100 of Fig. 1 when the cover 134 of the cooling plate 130 is omitted. Fig. 5 is a schematic view of the path of the working fluid when flowing in a cross section of the cooling assembly 100 of Fig. 1 taken along line 5-5. As shown in Fig. 4 and Fig. 5, the cooling plate 130 includes the base 132 and the cover 134 located on the base 132. The cover 134 is tightly connected to the base 132 to allow the working fluid to flow therein to prevent leakage of the working fluid. A side of the cooling plate 130 adjacent to the outlet O1 of the first chamber 112 and the inlet O2 of the second chamber 114 has an inlet O11 and an outlet O22, and the inlet O11 and the outlet O22 of the cooling plate 130 pass through the base 132. In this embodiment, the inlet O11 of the cooling plate 130 at least partially overlaps with the outlet O1 of the first chamber 112, and the outlet O22 of the cooling plate 130 at least partially overlaps with the inlet O2 of the second chamber 114. For example, the inlet O11 of the cooling plate 130 may be aligned with the outlet O1 of the first chamber 112 in a vertical direction, and the outlet O22 of the cooling plate 130 may be aligned with the inlet O2 of the second chamber 114 in the vertical direction. In addition, for example, the inlet O11 of the cooling plate 130 and the outlet O1 of the first chamber 112 are mated by male and female structures. As a result of such a design, the cooling plate 130 can be communicated with the lower-layer first and second chambers 112 and 114.

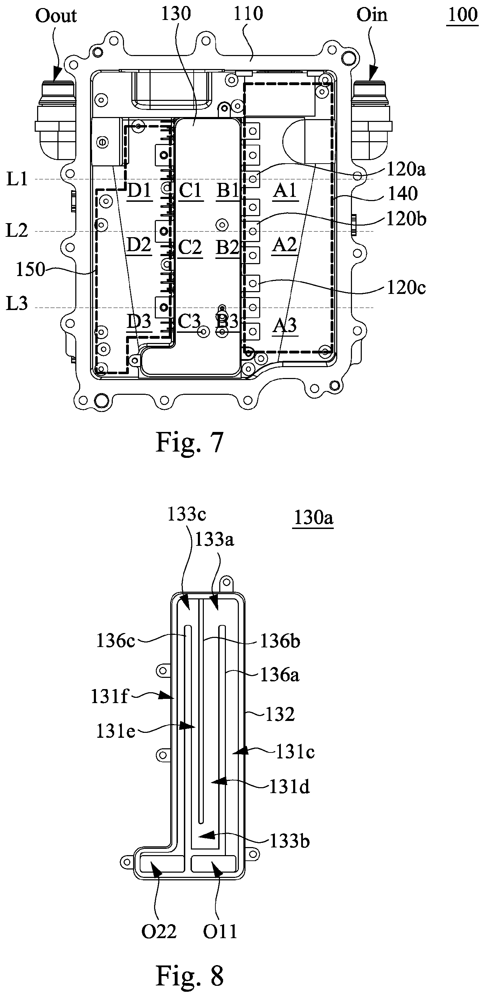

The cooling plate 130 includes at least two linear flow channels 131a and 131b and a curved flow channel 133. The curved flow channel 133 is communicated with same-side ends (e.g., the left ends of Fig. 4) of the two linear flow channels 131a and 131b. For example, the top view shape of the entirety of the two linear flow channels 131a and 131b and the curved flow channel 133 is U-shaped. In this embodiment, the base 132 of the cooling plate 130 has a partition 136 extending along the lengthwise direction of the base 132. The linear flow channels 131a and 131b and the curved flow channel 133 are defined by the partition 136, the base 132 and the cover 134 (may also see Fig. 1), such that the working fluid can flow along the linear flow channel 131a, the curved flow channel 133, and the linear flow channel 131b. The linear flow channels 131a and 131b and the curved flow channel 133 are located at the upper layer of the casing 110 relative to the aforementioned first and second chambers 112 and 114 (see Fig.3), and may serve as upper-layer flow channels. In another embodiment, the cooling plate 130 may include more linear flow channels and curved flow channels, and the number of the linear flow channels and the number of the curved flow channels do not limit the present disclosure, as shown in Fig. 8.

Fig. 6 is a schematic view of the path of the working fluid when flowing in the cooling plate 130 of Fig. 1. As shown in Fig. 5 and Fig. 6, an end of the linear flow channel 131a away from the curved flow channel 133 is communicated with the inlet O11 of the cooling plate 130, so that the water flow F1 of Fig. 3 may flows into the linear flow channel 131a through the outlet O1 of the first chamber 112 and the inlet O11 of the cooling plate 130, thereby forming the water flow F2 in a vertical direction and a water flow F3 that flows along the linear flow channel 131a. The water flow F3 is diverted by the curved flow channel 133 to form the a water flow F4. The water flow F3 and the water flow F4 can dissipate heat from the top portions of the power modules 120a, 120b, and 120c. An end of the linear flow channel 131b away from the curved flow channel 133 is communicated with the outlet O22 of the cooling plate 130, so that the water flow F4 can flow into the second chamber 114 through the outlet O22 of the cooling plate 130 and the inlet O2 of the second chamber, thereby forming a water flow F5 in a vertical direction.

Thereafter, after the water flow F5 flows into the second chamber 114, the water flow F6 of Fig. 3 may be formed.

Specifically, the top portions of the first chamber 112 and the second chamber 114 of the casing 110 respectively have the outlet O1 and the inlet O2 at the same-side ends of the first chamber 112 and the second chamber 114, the cooling plate 130 includes the linear flow channels 131a and 131b and the curved flow channel 133, and a side of the cooling plate 130 has the inlet O11 and the outlet O22. Therefore, when the working fluid flows from the first chamber 112 to the second chamber 114 and sequentially passes through the outlet O1 of the first chamber 112, the inlet O11 of the cooling plate 130, the linear flow channel 131a, the curved flow channel 133, the linear flow channel 131b, the outlet O22 of the cooling plate 130, and the inlet O2 of the second chamber 114, the two-layer flow of the working fluid in the lower-layer casing 110 and the upper-layer cooling plate 130, the two-way flow of the working fluid in the first chamber 112 and the second chamber 114 of the casing 110, and the two-way flow of the working fluid in the linear flow channels 131a and 131b of the cooling plate 130 can be realized.

It is to be noted that the connection relationships, the materials, and the advantages of the elements described above will not be repeated in the following description. In the following description, the advantages of the design of the aforementioned flow path will be explained.

Fig. 7 is a top view of the cooling assembly 100 of Fig. 1. After a working fluid with a lower temperature enters the water inlet Oᵢₙ, the aforementioned water flow F1 of Fig. 3, the water flow F2 of Fig. 5, the water flows F3 and F4 of Fig. 6, the water flow F5 of Fig. 5, and the water flow F6 of Fig. 5 can be sequentially formed, and the working fluid finally flows out from the water outlet Oₒᵤₜ. Different sections L1, L2, and L3 of the working fluid along the width direction of the cooling plate 130 have the same average temperature per unit area. In detail, heat generated by the power modules 120a, 120b, and 120c is substantially the same. Therefore, when the working fluid flows into the first chamber 112 (see Fig. 3), the temperature of the working fluid in areas A1, A2, and A3 of the first chamber 112 gradually increases due to the working fluid sequentially flowing below the power modules 120a, 120b, and 120c. In other words, the temperature of the working fluid gradually increases toward the outlet O1 of the first chamber 112. Thereafter, when the working fluid flows through the linear flow channel 131a (see Fig. 6), the temperature of the working fluid in areas B3, B2, and B1 of the linear flow channel 131a gradually increases due to the working fluid sequentially flowing over the power modules 120c, 120b, and 120a. In other words, the temperature of the working fluid gradually increases away from the inlet O22 of the cooling plate 130. Thereafter, when the working fluid flows through the linear flow channel 131b (see Fig. 6), the temperature of the working fluid in areas C1, C2, and C3 of the linear flow channel 131b gradually increases due to the working fluid sequentially flowing over the power modules 120a, 120b, and 120c. In other words, the temperature of the working fluid gradually decreases away from the outlet O22 of the cooling plate 130. Thereafter, when the working fluid flows into the second chamber 114 (see Fig. 3), the temperature of the working fluid in areas D3, D2, and D1 of the second chamber 114 gradually increases due to the working fluid sequentially flowing below the power modules 120c, 120b, and 120a. In other words, the temperature of the working fluid gradually increases away from the inlet O2 of the second chamber 114.

As a result, the temperature of the working fluid gradually increases along the areas A1, A2, A3, B3, B2, B1, C1, C2, C3, D3, D2, and D1, such that the average temperature per unit area of the working fluid in the areas A1, B1, C1, and D1 passed by the section L1, the average temperature per unit area of the working fluid in the areas A2, B2, C2, and D2 passed by the section L2, and the average temperature per unit area of the working fluid in the areas A3, B3, C3, and D3 passed by the section L3 are substantially the same. For example, "average temperature per unit area" substantially the same may be referred to as (sum of the average temperatures of the area B1 and the area C1):(sum of the average temperatures of the area B2 and the area C2):(sum of the average temperatures of the area B3 and the area C3) is substantially 1:1:1 under the unit area of each area. For another example, under the unit area of each area, (sum of the average temperatures of the areas A1, B1, C1, and D1):(sum of the average temperatures of the areas A2, B2, C2, and D2):(sum of the average temperatures of the areas A3, B3, C3, and D3) is substantially 1:1:1. Such a configuration can enable the power modules 120a, 120b, and 120c to be respectively located in heat dissipation environments that are relatively consistent, and a large difference between a temperature where the power module 120a is and a temperature where the power module 120c is will not occur.

As shown in Fig. 3 and Fig. 7, in some embodiments, the cooling assembly 100 may further include a capacitor module 140 and a bus bar module 150. The capacitor module 140 and the bus bar module 150 are disposed in the casing 110. For example, the capacitor module 140 at least partially overlaps with the first chamber 112, and the bus bar module 150 at least partially overlaps with the second chamber 114, and thus the water flow F1 flowing through the areas A1, A2, and A3 can simultaneously dissipate the heat generated from the capacitor module 140, and the water flow F6 flowing through the areas D3, D2, and D1 can simultaneously dissipate the heat generated from the bus bar module 150. In addition, in other embodiments, a driver board, an EMC shielding board, and a control board may be further disposed on the cooling plate 130 to facilitate cooling, but the present disclosure is not limited in this regard. It should be noted that the main heat source of a vehicle power supply is power modules. Therefore, the smallest unit of the present disclosure may enable at least one power module 120a to be in the areas B1 and C1 of the linear flow channels 131a and 131b passed by the section L1. Furthermore, the arrangement positions of at least two power modules 120a and120b in a row can be at least partially overlapped with the two continuous linear flow channels 131a and 131b, and the flow directions of the fluid in the flow channels are substantially opposite, so that the same average temperature per unit area can be achieved (the average temperature of the areas C1 and B1 relative to the average temperature of the areas C2 and B2). Accordingly, in addition to having the cooling plate 130, the cooling assembly 100 may further have a cooling structure in another layer, which cooperates with a continuous flow channel for fluid communication to achieve approximately the same average temperature per unit area is the concept that the present disclosure intends to express.

By the aforementioned design, the cooling assembly 100 merely has the single cooling plate 130 to provide water cooling for the power modules 120c, 120b, and 120a and other electronic components (e.g., the capacitor module 140 and the bus bar module 150) disposed in the casing, and thus material costs and occupied space can be effectively reduced, which is beneficial to a vehicle system. Moreover, since the cooling assembly 100 achieves two-layer flow and two-way flow, the working fluid does not easily generate an excessive temperature gradient, thereby maintaining module performance and extending service life.

Fig. 8 is a top view of a cooling plate 130a according to another embodiment of the present disclosure, in which the cover 134 of the cooling plate 130a is omitted. The difference between this embodiment and the aforementioned cooling plate 130 is that the cooling plate 130a of Fig. 8 includes four linear flow channels 131c, 131d, 131e, and 131f and three curved flow channels 133a, 133b, and 133c. The curved flow channel 133a is communicated with the same-side ends (e.g., the upper ends of Fig. 8) of the two linear flow channels 131c and 131d, the curved flow channel 133b is communicated with the same-side ends (e.g., the lower ends of Fig. 8) of the two linear flow channels 131d and 131e, and the curved flow channel 133c is communicated with the same-side ends (e.g., the upper ends of Fig. 8) of the two linear flow channels 131e and 131f. In this embodiment, the base 132 of the cooling plate 130a has three partitions 136a, 136b, and 136c extending along the lengthwise direction of the base 132, and the partition 136a is located between the linear flow channels 131c and 131d, the partition 136b is located between the linear flow channels 131d and 131e, the partition 136c is located between the linear flow channels 131e and 131f. The working fluid can flow along the linear flow channel 131c, the curved flow channel 133a, the linear flow channel 131d, the curved flow channel 133b, the linear flow channel 131e, the curved flow channel 133c, and the linear flow channel 131f. The cooling plate 130a may be used in the cooling assembly 100 of Fig. 1 to Fig. 7. In various embodiments, the number of the linear flow channels of a cooling plate may also be three.

The foregoing outlines features of several embodiments so that those skilled in the art may better understand the aspects of the present disclosure. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the spirit and scope of the present disclosure, and that they may make various changes, substitutions, and alterations herein without departing from the spirit and scope of the present disclosure.

## Claims

1. A cooling assembly, comprising:
a casing having a first chamber and a second chamber therein, wherein top portions of the first chamber and the second chamber respectively have an outlet and an inlet at same-side ends of the first chamber and the second chamber;
at least one power module located in the casing and at least partially overlapping with the first chamber and the second chamber; and
a cooling plate disposed on the power module, wherein a side of the cooling plate has an inlet and an outlet, the cooling plate comprises at least two linear flow channels and a curved flow channel communicated with same-side ends of the two linear flow channels, wherein when a working fluid flows from the first chamber to the second chamber and sequentially passes through the outlet of the first chamber, the inlet of the cooling plate, one of the two linear flow channels, the curved flow channel, the other of the two linear flow channels, the outlet of the cooling plate, and the inlet of the second chamber, different sections of the working fluid along a width direction of the cooling plate have a same average temperature per unit area.

2. The cooling assembly of claim 1, wherein the inlet of the cooling plate at least partially overlaps with the outlet of the first chamber, and the outlet of the cooling plate at least partially overlaps with the inlet of the second chamber.

3. The cooling assembly of claim 1, wherein one of the two linear flow channels is communicated with the inlet of the cooling plate, and when the working fluid flows through the one of the two linear flow channels, a temperature of the working fluid gradually increases away from the inlet of the cooling plate.

4. The cooling assembly of claim 1, wherein one of the two linear flow channels is communicated with the outlet of the cooling plate, and when the working fluid flows through the one of the two linear flow channels, a temperature of the working fluid gradually decreases away from the outlet of the cooling plate.

5. The cooling assembly of claim 1, wherein when the working fluid flows into the first chamber, a temperature of the working fluid gradually increases toward the outlet of the first chamber.

6. The cooling assembly of claim 1, wherein when the working fluid flows into the second chamber, a temperature of the working fluid gradually increases away from the inlet of the second chamber.

7. The cooling assembly of claim 1, wherein the cooling plate comprises a base and a cover located on the base, the base has a partition extending along a lengthwise direction of the base, and the partition is located between the two linear flow channels.

8. The cooling assembly of claim 7, wherein the inlet and the outlet of the cooling plate pass through the base.

9. The cooling assembly of claim 1, wherein the casing further comprises:
at least one flow guiding protruding rib located in the first chamber.

10. The cooling assembly of claim 1, wherein a top view shape of an entirety of the two linear flow channels and the curved flow channel is U-shaped.

11. The cooling assembly of claim 1, wherein the two linear flow channels and the curved flow channel are located on an upper layer of the casing, the first chamber and the second chamber are located on a lower layer of the casing, and the first chamber is separated from the second chamber.

12. The cooling assembly of claim 1, further comprising:
a capacitor module disposed in the casing and at least partially overlapping with the first chamber.

13. The cooling assembly of claim 1, further comprising:
a bus bar module disposed in the casing and at least partially overlapping with the second chamber.

14. A cooling assembly, comprising:
a casing having a first chamber and a second chamber therein, wherein top portions of the first chamber and the second chamber respectively have an outlet and an inlet at same-side ends of the first chamber and the second chamber;
at least one power module located in the casing and at least partially overlapping with the first chamber and the second chamber; and
a cooling plate disposed on the power module, wherein a side of the cooling plate has an inlet and an outlet, the cooling plate comprises at least two linear flow channels and a curved flow channel communicated with same-side ends of the two linear flow channels, one of the two linear flow channels is communicated with the inlet of the cooling plate, and the other of the two linear flow channels is communicated with the outlet of the cooling plate, wherein when a working fluid flows through the one of the two linear flow channels, a temperature of the working fluid gradually increases away from the inlet of the cooling plate, and when the working fluid flows through the other of the two linear flow channels, a temperature of the working fluid gradually decreases away from the outlet of the cooling plate.

15. The cooling assembly of claim 14, wherein the inlet of the cooling plate at least partially overlaps with the outlet of the first chamber, and the outlet of the cooling plate at least partially overlaps with the inlet of the second chamber.

16. The cooling assembly of claim 14, wherein when the working fluid flows into the first chamber, a temperature of the working fluid gradually increases toward the outlet of the first chamber.

17. The cooling assembly of claim 14, wherein when the working fluid flows into the second chamber, a temperature of the working fluid gradually increases away from the inlet of the second chamber.

18. The cooling assembly of claim 14, wherein the cooling plate comprises a base and a cover located on the base, the base has a partition extending along a lengthwise direction of the base, and the partition is located between the two linear flow channels.

19. The cooling assembly of claim 14, wherein the two linear flow channels and the curved flow channel are located on an upper layer of the casing, the first chamber and the second chamber are located on a lower layer of the casing, and the first chamber is separated from the second chamber.

20. The cooling assembly of claim 14, wherein the casing further comprises:
at least one flow guiding protruding rib located in the first chamber.
